# FASCICULE DE BREVET EUROPEEN

(11) **EP 2 430 378 B1**
(45) Date de publication et mention de la délivrance du brevet: **27.10.2021**
(21) Numéro de dépôt: 10728747.6
(22) Date de dépôt: 12.05.2010
(51) Int. Cl.: H02S 20/23, H02S 20/10, H02S 20/26, F24S 25/632, F24S 25/65, F24S 25/12, H01L 31/18, F24S 25/00, F24S 25/60

(54) **ARRANGEMENT COMPRENANT UN DISPOSITIF DE FIXATION ET PROCEDE DE MONTAGE DE CET ARRANGEMENT**
ANORDNUNG UMFASSEND EINE BEFESTIGUNGSVORRICHTUNG UND VERFAHREN ZUR MONTAGE DIESER ANORDNUNG
ARRANGEMENT COMPRISING AN ATTACHMENT DEVICE AND METHOD FOR MOUNTING THIS ARRANGEMENT

(30) Priorité: 12.05.2009 FR 0953119
(43) Date de publication de la demande: 21.03.2012
(73) Titulaire: (CNBM) Bengbu Design & Research Institute for Glass Industry Co., Ltd., Bengbu (CN)
(72) Inventeur: KUSTER, Hans-Werner, 52066 Aachen (DE); KUSTER, Felix, 52066 Aachen (DE)
(74) Mandataire: Evans, Huw David Duncan
(86) Numéro de dépôt international: PCT/FR2010/050922
(87) Numéro de publication internationale: WO 2010/130952

(56) Documents cités:
- EP-A2- 1 070 923
- WO-A1-00/12839
- DE-U1-202006 018 426
- DE-U1-202007 003 060
- DE-U1-202008 015 237
- US-A- 4 254 813
- None

## Description

La présente invention a trait à un arrangement comprenant un dispositif de fixation d'un module de récupération d'énergie issue du rayonnement solaire sur une structure, telle qu'un toit, une façade ou une structure porteuse en plein champ, et à un procédé de montage d'au moins un module de récupération d'énergie issue du rayonnement solaire sur une structure.

Au sens de l'invention, un module de récupération d'énergie issue du rayonnement solaire peut être, notamment, un module solaire photovoltaïque, apte à convertir l'énergie issue du rayonnement solaire en énergie électrique, un module solaire thermique, apte à convertir l'énergie issue du rayonnement solaire en énergie thermique récupérée dans un fluide caloporteur, ou encore un module solaire mixte mettant en œuvre ces deux types de conversion énergétique.

De manière connue, un module solaire photovoltaïque se présente sous la forme d'un vitrage feuilleté comprenant des cellules photovoltaïques intercalées entre un substrat avant transparent, destiné à être disposé du côté d'incidence du rayonnement solaire sur le module, et un substrat arrière transparent ou opaque, destiné à être agencé en regard d'une structure de montage du module. Les substrats avant et arrière peuvent notamment être formés par des plaques de verre ou de polymère thermoplastique. Afin de permettre le montage du module photovoltaïque sur une structure, telle qu'un toit ou une façade de bâtiment, ou encore une structure porteuse en plein champ, le module est classiquement équipé d'un cadre métallique, notamment constitué en aluminium, qui recouvre sa périphérie. La fixation du module sur la structure de montage est alors obtenue par solidarisation du cadre avec la structure et/ou avec le cadre d'un autre module, dans le cas du montage de plusieurs modules juxtaposés.

La solidarisation du cadre de chaque module avec la structure de montage et, éventuellement, avec les cadres de modules adjacents s'opère le plus souvent par vissage ou boulonnage. Il en résulte un temps de montage relativement long des modules photovoltaïques sur la structure, de même qu'un temps de démontage relativement long en cas de panne d'un ou plusieurs modules. Par ailleurs, la présence d'un cadre métallique à la périphérie de chaque module et la fixation du module sur la structure au niveau de ce cadre entraînent l'apparition de contraintes mécaniques sur la périphérie du module, ce qui nuit à la résistance mécanique du module. De plus, le cadre métallique de chaque module recouvre des parties de surface active à la périphérie du module qui, si elles n'étaient pas recouvertes, participeraient à la conversion d'énergie, ce qui limite le rendement du module.

Des problèmes analogues se posent avec les modules solaires thermiques ou mixtes photovoltaïques/thermiques.

C'est à ces inconvénients qu'entend plus particulièrement remédier l'invention en proposant un dispositif de fixation permettant un montage rapide et fiable de modules solaires sur une structure de réception, sans fragilisation de la structure des modules, ainsi qu'un remplacement aisé des modules une fois montés sur une structure, en cas de panne.

Le documents EP 1070923 A2 et JP-.A-409195473 décrivent arrangements avec dispositifs de fixation dans l'état de la technique antérieure.

A cet effet, l'invention a pour objet un arrangement comprenant un dispositif de fixation d'au moins un module de récupération d'énergie issue du rayonnement solaire sur une structure, telle qu'un toit, une façade ou une structure porteuse en plein champ, avec les caractéristiques de la revendication 1.

Au sens de l'invention, la face arrière du module est la face du module qui est positionnée en regard de la structure lorsque le module est fixé sur la structure.

Selon d'autres caractéristiques avantageuses d'un dispositif de fixation selon l'invention, prises isolément ou selon toutes les combinaisons techniquement possibles :
- les moyens d'encliquetage comprennent au moins une languette du support propre à coopérer par encliquetage avec une encoche du profilé de renfort du module ;
- la languette définit une rainure de réception d'un bord de l'encoche, cette rainure étant ouverte en direction de la structure ;
- le dispositif comprend, en tant que moyens de verrouillage des moyens d'encliquetage dans leur état activé, des moyens élastiques de poussée du module à l'écart de la structure pour le maintien du bord de l'encoche à l'intérieur de la rainure ;
- le profilé de renfort comporte un orifice de déverrouillage qui, dans l'état activé des moyens d'encliquetage, est en regard de la languette, les moyens d'encliquetage étant aptes à passer de leur état activé à un état désactivé sous l'effet combiné d'un effort de poussée du module en direction de la structure à l'encontre des moyens élastiques et d'un effort de poussée de la languette à l'écart de l'encoche exercé à travers l'orifice de déverrouillage ;
- le profilé de renfort comporte au moins une partie à section transversale en U sensiblement complémentaire de la section transversale en U d'une partie du support, ces parties en U étant en prise l'une dans l'autre dans l'état activé des moyens d'encliquetage ;
- le dispositif comprend au moins un pion solidaire de l'un parmi le profilé de renfort et le support, ce pion étant propre à coopérer avec un orifice de l'autre parmi le profilé de renfort et le support pour l'alignement des moyens d'encliquetage du support par rapport au profilé de renfort ;
- le support est un flan métallique plié et découpé pour former les moyens d'encliquetage ;
- le profilé de renfort est décalé intérieurement par rapport aux bords périphériques du module ;
- le profilé de renfort est de forme allongée et adapté pour coopérer par encliquetage avec un support au niveau de chacune de ses extrémités ;
- le dispositif comprend au moins deux profilés de renfort solidaires de ladite face du module et régulièrement répartis sur ladite face du module ;
- le module est un module photovoltaïque dépourvu de cadre, qui comprend un substrat avant, un substrat arrière et au moins une cellule photovoltaïque intercalée entre les substrats avant et arrière, le ou chaque profilé de renfort étant solidaire d'une face arrière du substrat arrière opposée à la cellule photovoltaïque.

L'invention a également pour objet un procédé de montage d'un arrangement selon l'une quelconques des revendications précédentes, comprenant des étapes dans lesquelles :
- on solidarise au moins un support avec la structure ;
- on aligne les moyens d'encliquetage du support par rapport au profilé de renfort ;
- on active les moyens d'encliquetage par l'application d'un effort unidirectionnel de poussée du module en direction de la structure.

Les caractéristiques et avantages de l'invention apparaîtront dans la description qui va suivre d'un mode de réalisation d'un dispositif de fixation et d'un procédé de montage selon l'invention, donnée uniquement à titre d'exemple et faite en se référant aux dessins annexés dans lesquels :
- la figure 1 est une vue en perspective de modules solaires photovoltaïques montés sur une structure porteuse au moyen d'un dispositif de fixation conforme à l'invention ;
- la figure 2 est une vue en perspective partielle selon la flèche II de la figure 1, avec deux modules photovoltaïques montés sur la structure porteuse, l'un des modules ayant été rendu transparent pour permettre la visualisation de ses profilés de renfort ;
- la figure 3 est une vue en perspective de dessous d'un module photovoltaïque de la figure 2 muni de profilés de renfort ;
- la figure 4 est une vue analogue à la figure 3, mais en perspective éclatée ;
- la figure 5 est une vue à plus grande échelle du détail V de la figure 2 ;
- la figure 6 est une coupe selon le plan VI de la figure 2 ; et
- la figure 7 est une vue en perspective selon la flèche VII de la figure 2.

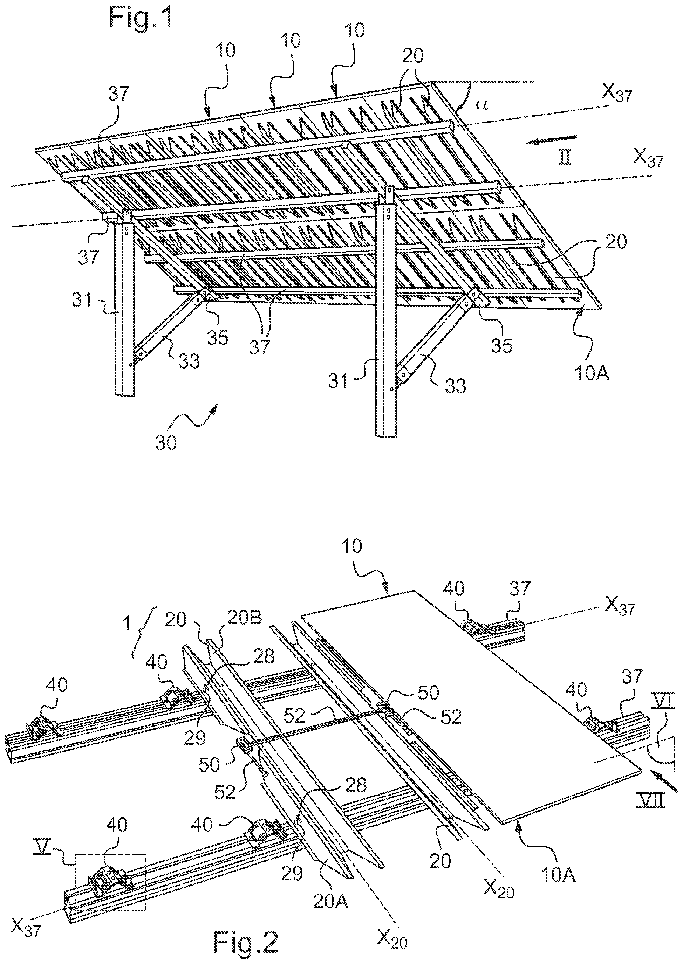

Sur la figure 1 sont représentés des modules photovoltaïques 10, montés sur une structure porteuse 30 de type structure porteuse en plein champ. La structure 30 est adaptée pour recevoir les modules 10 avec une inclinaison de chaque module d'angle α par rapport à l'horizontale, prévue pour maximiser le rayonnement solaire incident sur le module. Sur la figure 1, les éléments de connectique et d'acheminement du courant électrique ont été omis pour une meilleure clarté du dessin. La structure 30 est une structure en acier inoxydable comprenant une pluralité de poutrelles 31, 33, 35 agencées entre elles de manière à former une charpente triangulée, sur laquelle sont fixées des traverses 37. Les traverses 37, dont on note X₃₇ un axe longitudinal, sont parallèles entre elles et destinées à recevoir une pluralité de modules photovoltaïques 10 juxtaposés, chaque module photovoltaïque 10 étant monté sur la structure 30 au moyen d'un dispositif de fixation 1 conforme à l'invention. Dans l'exemple représenté sur les figures, chaque module 10 est pourvu sur sa face arrière 10A de deux profilés de renfort 20 et le dispositif de fixation 1 comprend, pour chaque module 10, quatre supports 40 solidaires de la structure.

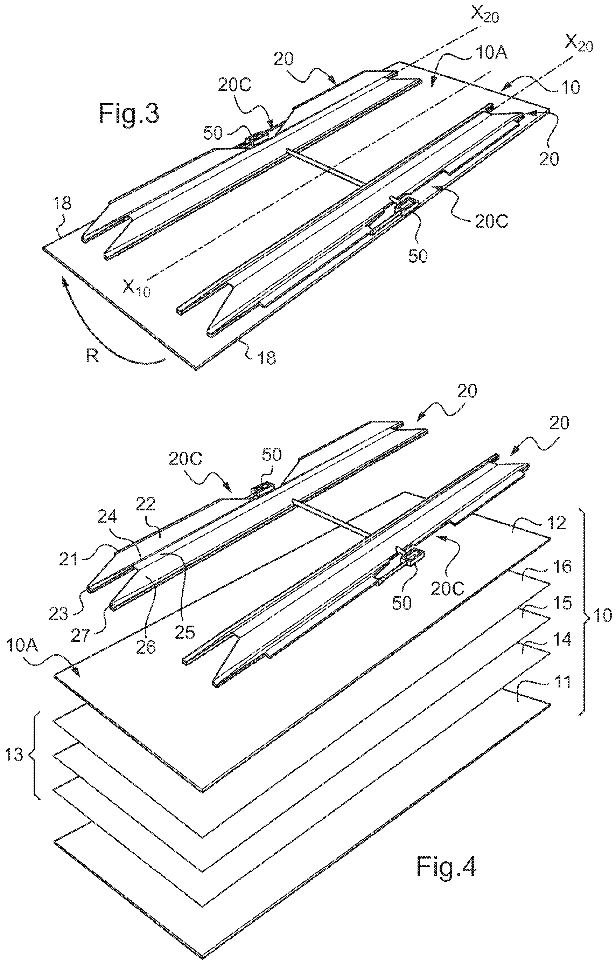

Comme montré sur les figures 3 et 4, chaque module 10 de ce mode de réalisation est un module photovoltaïque dépourvu de cadre, qui comprend un substrat avant 11, un substrat arrière 12 et une ou plusieurs cellules photovoltaïques 13 intercalées entre les substrats avant 11 et arrière 12. Le substrat avant 11, destiné à être agencé du côté d'incidence du rayonnement solaire sur le module 10, est transparent, par exemple constitué en un verre transparent extra-clair ou en un polymère thermoplastique transparent tel que le polycarbonate, le polyuréthane ou le polyméthacrylate de méthyle. Le substrat arrière 12, destiné à être agencé en regard de la structure 30, est constitué en tout matériau approprié, transparent ou non, notamment en verre.

La ou chaque cellule photovoltaïque 13 positionnée entre les substrats 11 et 12 est formée par un empilement de couches minces comprenant successivement, à partir du substrat avant 11, une couche 14 transparente électriquement conductrice, notamment à base d'oxyde conducteur transparent (Transparent Conductive Oxide ou TCO), qui forme une électrode avant de la cellule ; une couche 15 d'absorbeur, propre à assurer la conversion de l'énergie issue du rayonnement solaire incident sur la cellule en énergie électrique, notamment une couche mince à base de silicium, amorphe ou microcristallin, ou à base de tellurure de cadmium; et une couche 16 électriquement conductrice qui forme une électrode arrière de la cellule.

En variante, la couche 15 d'absorbeur de la ou chaque cellule 13 peut être une couche mince de composé chalcopyrite comportant du cuivre, de l'indium et du sélénium, dite couche d'absorbeur CIS, éventuellement additionnée de gallium (couche d'absorbeur CIGS), d'aluminium ou de soufre. Dans ce cas, la ou chaque cellule 13 à couches minces comprend un empilement analogue à celui décrit ci-dessus, un intercalaire de feuilletage polymère non représenté étant en outre positionné entre l'électrode avant 14 de la cellule et le substrat avant 11, afin de garantir une bonne cohésion du module 10 lors de son assemblage. L'intercalaire de feuilletage peut notamment être constitué en polybutyral de vinyle (PVB) ou en éthylène vinylacétate (EVA).

Selon encore une autre variante, la ou chaque cellule 13 peut être constituée à partir de « wafers » ou galettes de silicium polycristallin ou monocristallin formant une jonction p/n.

Comme visible sur la figure 2, chaque module 10 comporte deux profilés de renfort 20 solidaires de sa face arrière 10A destinée à être en regard de la structure 30, qui est la face du substrat arrière 12 opposée à la ou chaque cellule photovoltaïque 13. Chaque profilé de renfort 20 est de forme allongée d'axe longitudinal X₂₀ et est adapté pour coopérer par encliquetage avec un support 40 au niveau de chacune de ses extrémités 20A et 20B. Les quatre supports 40 de réception d'un module 10 sont répartis par paires sur deux traverses 37 voisines, de telle sorte qu'en configuration encliquetée des deux profilés 20 du module sur les quatre supports 40 correspondants, l'axe longitudinal X₂₀ de chaque profilé 20 est orienté transversalement par rapport à l'axe X₃₇ des traverses 37. Lorsque chacun des deux profilés de renfort 20 d'un module 10 coopère par encliquetage avec deux supports 40, le module 10 est immobilisé par rapport à la structure 30.

De manière avantageuse, comme montré sur la figure 3, les deux profilés de renfort 20 de chaque module 10 sont disposés sur la face arrière 10A du module avec leurs axes longitudinaux X₂₀ parallèles entre eux et à deux bords périphériques 18 opposés du module, de sorte que, lorsque le module 10 est monté sur la structure 30, les profilés 20 s'étendent perpendiculairement aux traverses 37. Un tel agencement favorise les mouvements de convection d'air à l'arrière du module 10, et donc le refroidissement du module. De préférence, chaque profilé 20 est décalé intérieurement par rapport au bord latéral 18 correspondant du module 10, de manière à renforcer la structure du module et à améliorer sa résistance mécanique.

Dans ce mode de réalisation, chaque profilé de renfort 20 d'un module 10 est constitué en acier inoxydable et formé à partir d'un unique flan découpé et plié. Chaque profilé 20 a une section transversale globalement en forme de deux omégas imbriqués l'un dans l'autre. Plus précisément, chaque oméga 21-25 ou 23-27 comprend deux branches, 21, 25 ou 23, 27, qui encadrent une partie centrale 22-24 ou 24-26 de l'oméga. Chaque partie centrale 22-24 ou 24-26 comporte une paroi de fond et deux parois latérales obliques par rapport à la paroi de fond, les deux omégas étant imbriqués de telle sorte que le fond 23 ou 25 de la partie centrale d'un oméga forme une branche de l'autre oméga. Les parois 21, 23, 25 et 27 du profilé 20, qui forment les fonds et les branches des omégas, sont sensiblement planes et destinées à venir en regard, respectivement, de la face arrière 10A du module 10, pour les parois 23 et 27, et de la structure 30, pour les parois 21 et 25.

Les deux profilés de renfort 20 de chaque module 10 sont solidarisés directement avec la face arrière 10A du module par collage des parois 23 et 27 contre la face 10A, au moyen d'un matériau adhésif. Comme visible sur les figures 3 et 4, les parois 21 et 22 de chaque profilé 20 délimitent une échancrure 20C au niveau d'une portion médiane du profilé par rapport à sa direction longitudinale. Cette échancrure 20C est obtenue par découpe du flan constitutif du profilé 20, avant pliage de ce flan. L'échancrure 20C de chaque profilé 20 crée un évidement de matière permettant la mise en place d'une boîte de connexion 50 sur la face 10A arrière du module. Chaque module est ainsi équipé de deux boîtes de connexion 50, logées chacune au niveau de l'échancrure 20C d'un profilé 20. Les boîtes de connexion 50 d'un module 10 sont reliées entre elles et avec l'extérieur au moyen de câbles 52, ce qui permet le raccordement électrique du module 10, une fois monté sur la structure 30, avec des modules 10 adjacents et des dispositifs non représentés de mise à disposition de courant électrique.

De manière particulièrement avantageuse, les deux profilés de renfort 20 d'un module 10 sont identiques l'un à l'autre et agencés sur la face arrière 10A du module de manière symétrique l'un de l'autre par rapport à un axe médian X₁₀ du module. En particulier, comme montré par la flèche R de la figure 3, il suffit de procéder à une rotation de 180° d'un profilé 20 sur lui-même pour réaliser le positionnement des deux profilés 20 sur la face 10A, à partir d'un modèle unique de profilé. Il en résulte la possibilité de produire le profilé 20 en grande série, par découpe et pliage de flans en acier, et ainsi de réduire son coût de fabrication. En variante, les profilés 20 peuvent être constitués en tout matériau autre que l'acier et adapté à leur fonction, notamment en un autre matériau métallique ou en un matériau synthétique, le profilé étant dans ce dernier cas obtenu par extrusion du matériau synthétique.

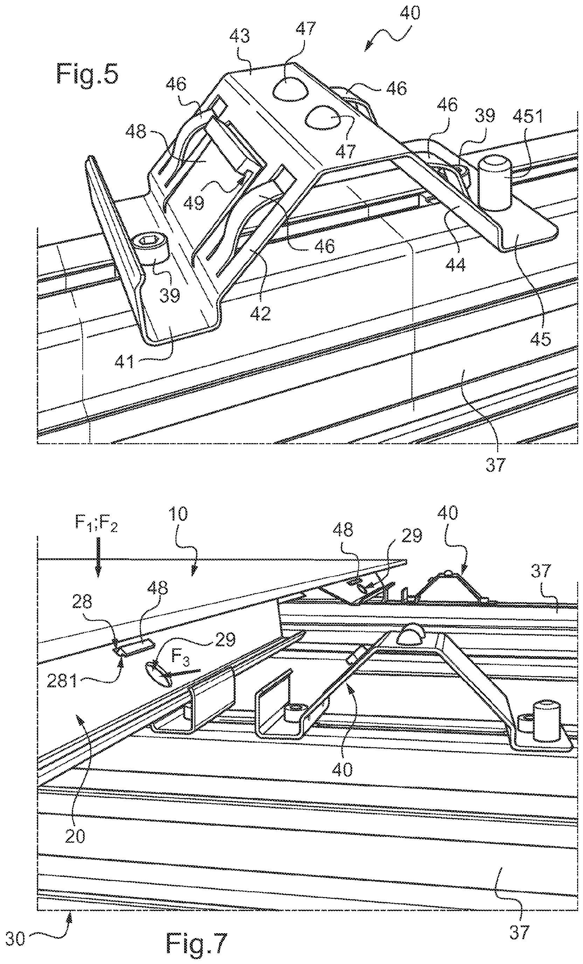

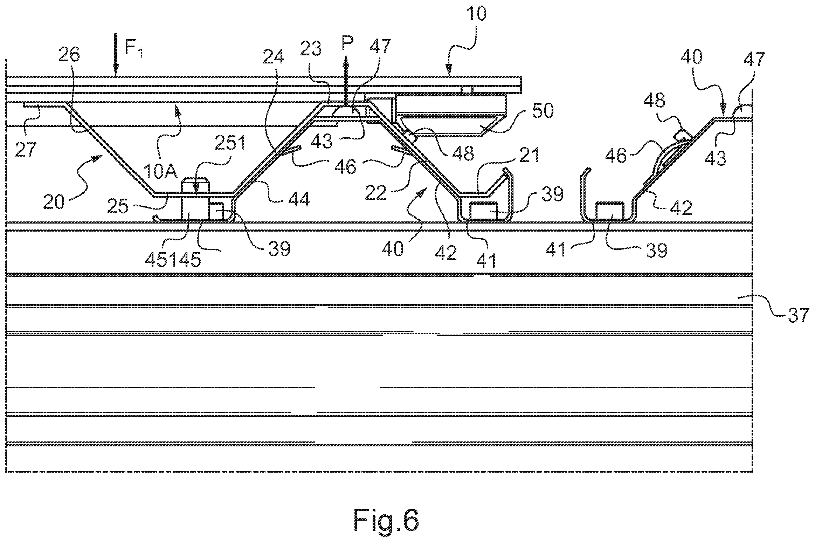

Chaque support 40 du dispositif de fixation 1 est fixé sur la traverse 37 correspondante au moyen de deux vis 39. Chaque support 40 est constitué en acier inoxydable et formé à partir d'un unique flan plié et découpé. Les supports 40 sont identiques entre eux et présentent chacun une section transversale globalement en forme d'oméga, comprenant deux branches 41 et 45 qui encadrent une partie centrale 42-44 de l'oméga. La partie centrale de l'oméga comporte une paroi de fond 43 et deux parois latérales 42 et 44 obliques par rapport à la paroi de fond 43. Comme montré sur la figure 6, cette partie centrale 42-44 de chaque support 40 est prévue avec une section transversale en U sensiblement complémentaire de la section transversale en U de la partie 22-24 de chaque profilé 20. En particulier, la partie 22-24 de chaque profilé 20 du module est apte à venir coiffer simultanément la partie centrale 42-44 de deux supports 40 agencés sur deux traverses 37 voisines, comme montré sur la figure 7. La paroi de fond 43 de chaque support 40 est équipée de butées élastiques 47, destinées à recevoir en appui la paroi 23 d'un profilé 20 coiffant le support.

Afin de garantir un positionnement optimal d'un module 10 par rapport à la structure 30 en vue de la fixation du module sur la structure, au moins l'un des quatre supports 40 associés au module est muni d'un pion d'alignement 451, au niveau de sa paroi 45. Ce pion 451 est destiné à coopérer avec un orifice 251 complémentaire prévu dans la paroi 25 d'au moins un profilé de renfort 20 du module, au voisinage de l'extrémité 20A ou 20B du profilé. La coopération entre le pion d'alignement 451 et l'orifice 251 correspondant, combinée à la venue en prise relative des parties en U 22-24 des profilés et 42-44 des supports, permet une indexation fiable de la position du module sur la structure préalablement à leur immobilisation relative, ce qui contribue à faciliter le montage du module sur la structure.

Pour la fixation des modules 10 sur la structure 30, la paroi latérale 42 de chaque support 40 comporte une languette 48 prévue pour coopérer par encliquetage avec une encoche 28 ménagée dans la paroi latérale 22 de chaque profilé de renfort 20. Plus précisément, comme visible sur la figure 2, la paroi latérale 22 de chaque profilé 20 comporte deux encoches 28, disposées chacune au voisinage d'une extrémité 20A, 20B du profilé. Ainsi, lorsque la partie 22-24 d'un profilé de renfort 20 coiffe simultanément la partie 42-44 de deux supports 40 agencés sur deux traverses 37 voisines, la languette 48 de chacun des deux supports 40 est apte à s'encliqueter dans l'une des deux encoches 28 du profilé. Dans l'état encliqueté d'une languette 48 par rapport à une encoche 28, un bord inférieur 281 de l'encoche est reçu dans une rainure 49 délimitée par la languette 48 et ouverte en direction de la structure 30. Dans ce mode de réalisation, la fixation de chaque module 10 sur la structure 30 met en jeu l'encliquetage des languettes 48 de quatre supports 40 dans quatre encoches 28, réparties par paires sur les deux profilés de renfort 20 du module. Dans l'état activé des moyens d'encliquetage que constituent ces quatre couples de languettes 48 et encoches 28, les deux profilés de renfort 20 du module 10 sont immobilisés par rapport aux quatre supports 40, de sorte que le module 10 est fixé par rapport à la structure 30.

La paroi latérale 42 de chaque support 40 comporte également, de part et d'autre de la languette 48, deux lames élastiques 46 découpées dans la structure en acier du support 40. Deux lames élastiques 46 sont également découpées dans la paroi latérale 44 de chaque support 40, de manière symétrique par rapport à un plan médian du support. Les quatre lames élastiques 46 sont propres à exercer, sur les parois 22 et 24 d'un profilé 20 coiffant le support 40, un effort de poussée du profilé 20 à l'écart du support 40, et donc du module 10 à l'écart de la structure 30, comme montré par la flèche P de la figure 6. L'effort de poussée P exercé par les lames élastiques 46 sur le profilé de renfort 20 permet un verrouillage des moyens d'encliquetage 28 et 48 dans leur état activé, en maintenant le bord 281 de l'encoche 28 à l'intérieur de la rainure 49.

Outre les deux encoches 28, la paroi latérale 22 de chaque profilé de renfort 20 d'un module 10 comporte également deux orifices 29, situés chacun au voisinage de l'une des encoches 28 de telle sorte que, dans la configuration encliquetée d'une languette 48 par rapport à l'encoche 28, l'orifice 29 est en regard de la languette 48. Grâce à cet agencement, il est possible de désactiver les moyens d'encliquetage d'un module 10 monté sur la structure 30, c'est-à-dire de déverrouiller l'assemblage. Comme montré sur la figure 7, un tel déverrouillage est obtenu en appliquant à la fois un effort F₂ de poussée du module 10 en direction de la structure 30, à l'encontre de la poussée élastique P des lames 46, et un effort F₃ de poussée de chaque languette 48 coopérant avec un profilé de renfort du module 10 à l'écart de l'encoche 28 correspondante. L'effort de poussée F₃ est exercé à travers l'orifice 29 voisin de l'encoche 28, à l'aide de tout outil approprié.

Un procédé de montage de modules photovoltaïques 10 sur la structure 30 au moyen du dispositif de fixation 1 conforme à l'invention comprend des étapes telles que décrites ci-après.

Tout d'abord, on équipe le module 10 avec ses deux profilés de renfort 20, par collage des parois 23 et 27 des profilés de renfort contre la face 10A du module, selon l'agencement montré sur la figure 3.

On solidarise également des supports 40 avec la structure 30, par vissage au moyen de vis 39, en disposant les supports 40 sur les traverses 37 de la structure avec un espacement approprié, correspondant à l'espacement entre les encoches 28 des profilés de renfort 20.

Le montage de chaque module 10 sur la structure 30 s'opère ensuite de la façon suivante. Dans un premier temps, on aligne mutuellement les moyens d'encliquetage 28 et 48. A cet effet, on met en prise la partie centrale en U 42-44 de deux supports 40 agencés sur deux traverses 37 voisines, à l'intérieur de la partie en U 22-24 correspondante de chacun des deux profilés de renfort 20 du module 10. Ce faisant, on introduit également le pion d'alignement 451, prévu sur au moins l'un des quatre supports 40 associés au module 10, dans l'orifice 251 correspondant d'au moins un profilé de renfort 20 du module 10. A l'issue de cette étape, les languettes 48 et encoches 28 formant moyens d'encliquetage sont alignées deux à deux. On applique alors un effort unidirectionnel F₁ de poussée du module 10 en direction de la structure 30, de manière à activer les moyens d'encliquetage, c'est-à-dire à encliqueter la languette 48 de chacun des quatre supports 40 associés au module dans l'encoche 28 qui est alignée avec la languette.

De manière avantageuse, l'étape de solidarisation des profilés de renfort 20 avec les modules 10 peut être réalisée sur le site de fabrication des modules 10, alors que les étapes suivantes sont réalisées sur le site de montage des modules 10.

Dans le cas où il est nécessaire de retirer ou de remplacer un module 10 monté sur la structure 30, par exemple en cas de panne de ce module, le démontage du module 10 s'opère de manière particulièrement simple, en appliquant simultanément un effort F₂ de poussée du module 10 en direction de la structure 30, à l'encontre de la poussée élastique P des lames 46, et un effort F₃ de poussée de chaque languette 48 coopérant avec un profilé de renfort du module 10 à l'écart de l'encoche 28 correspondante, à travers l'orifice 29 voisin de l'encoche 28.

Comme il ressort du mode de réalisation décrit précédemment, le dispositif de fixation conforme à l'invention permet un montage rapide et aisé de modules solaires sur une structure, telle qu'une structure porteuse en plein champ, par l'application d'un effort F₁ unidirectionnel de poussée sur chaque module préalablement positionné sur la structure, sans nécessiter d'outillage particulier. Cet effort de poussée actionne l'encliquetage de profilés de renfort du module par rapport à des supports solidaires de la structure. Le positionnement du module sur la structure pour l'alignement préalable des moyens d'encliquetage des supports par rapport aux profilés de renfort est également aisé, en particulier grâce à la forme complémentaire de certaines parties 22-24 et 42-44 des profilés de renfort 20 et des supports 40.

Grâce à l'action élastique des moyens de verrouillage 46, qui maintiennent les moyens d'encliquetage dans un état activé, la fixation obtenue des modules sur la structure est fiable et robuste. De plus, les éléments constitutifs du dispositif de fixation conforme à l'invention, à savoir les profilés de renfort 20 et les supports 40, présentent l'avantage de pouvoir être fabriqués de manière simple et économique, par pliage et découpe de flans en acier, de façon à définir les moyens d'encliquetage et de verrouillage. En outre, l'assemblage des modules avec la structure obtenu selon l'invention est réversible, grâce à la présence des orifices de déverrouillage 29, qui permettent un démontage individuel d'un module par rapport à la structure, en cas de panne de ce module.

Par ailleurs, la présence des profilés de renfort 20 de forme allongée, régulièrement répartis à l'arrière de chaque module, améliore la résistance mécanique des modules et, dans la mesure où il n'est plus nécessaire d'avoir un cadre autour de la périphérie du module pour obtenir sa fixation sur une structure, toute la surface active du module est exposée au rayonnement solaire, ce qui garantit un rendement optimal du module.

L'invention n'est pas limitée aux exemples décrits et représentés. En particulier, l'arrangement selon l'invention peut mettre en jeu des organes d'encliquetage autres que des languettes et encoches, ou encore un nombre d'encoches et de languettes différents de ce qui a été décrit précédemment. Le nombre et la forme des profilés de renfort 20 associés à chaque module peuvent également être différents de ceux décrits précédemment, les profilés de renfort étant avantageusement répartis régulièrement sur la face 10A du module de manière à renforcer la structure du module. De plus, l'arrangement selon l'invention peut être mis en œuvre pour le montage sur une structure de modules équipés ou non de cadres périphériques, l'option sans cadre étant toutefois préférée. L'arrangement selon l'invention peut également être utilisé pour le montage de modules solaires de tout type, sur une structure de réception également de tout type. En particulier, les modules solaires photovoltaïques décrits précédemment peuvent être remplacés par des modules solaires thermiques ou mixtes photovoltaïques/thermiques, et la structure de réception peut être indifféremment une structure porteuse en plein champ, un toit ou une façade.

## Revendications

1. Arrangement comprenant:
- un dispositif (1) de fixation d'un module (10) de récupération d'énergie issue du rayonnement solaire sur une structure (30), telle qu'un toit, une façade ou une structure porteuse en plein champ,
- un module (10) de récupération d'énergie issue du rayonnement solaire,
où le module (10) est pourvu sur sa face arrière (10A) d'au moins un profilé de renfort (20), où le au moins un profilé de renfort (20) est décalé intérieurement par rapport aux bords périphériques (18) du module (10) et où le dispositif de fixation comprend au moins un support (40) solidaire de la structure (30), ce au moins un support (40) comportant des moyens (48) d'encliquetage par rapport au profilé de renfort (20) du module, qui sont aptes à être activés par l'application d'un effort unidirectionnel (F₁) de poussée du module (10) en direction de la structure (30), **caractérisé en ce que** le au moins un support (40) comporte, pour le verrouillage des moyens d'encliquetage dans leur état activé, des moyens élastiques (46) de poussée (P) du module (10) à l'écart de la structure (30).

2. Arrangement selon la revendication 1, **caractérisé en ce que** les moyens d'encliquetage comprennent au moins une languette (48) du support (40) propre à coopérer par encliquetage avec une encoche (28) du profilé de renfort (20).

3. Arrangement selon la revendication 2, **caractérisé en ce que** la languette (48) définit une rainure (49) de réception d'un bord (281) de l'encoche (28), cette rainure (49) étant ouverte en direction de la structure (30).

4. Arrangement selon la revendication 3, **caractérisé en ce qu'**il comprend, en tant que moyens de verrouillage des moyens d'encliquetage dans leur état activé, des moyens élastiques (46) de poussée (P) du module (10) à l'écart de la structure (30) pour le maintien du bord (281) à l'intérieur de la rainure (49).

5. Arrangement selon la revendication 4, **caractérisé en ce que** le profilé de renfort (20) comporte un orifice de déverrouillage (29) qui, dans l'état activé des moyens d'encliquetage, est en regard de la languette (48), les moyens d'encliquetage étant aptes à passer de leur état activé à un état désactivé sous l'effet combiné d'un effort (F₂) de poussée du module (10) en direction de la structure (30) à l'encontre des moyens élastiques (46) et d'un effort (F₃) de poussée de la languette (48) à l'écart de l'encoche (28) exercé à travers l'orifice de déverrouillage (29).

6. Arrangement selon l'une quelconque des revendications précédentes, **caractérisé en ce que** le profilé de renfort (20) comporte au moins une partie (22-24) à section transversale en U sensiblement complémentaire de la section transversale en U d'une partie (42-44) du support (40), ces parties en U (22-24, 42-44) étant en prise l'une dans l'autre dans l'état activé des moyens d'encliquetage.

7. Arrangement selon l'une quelconque des revendications précédentes, **caractérisé en ce qu'**il comprend au moins un pion (451) solidaire de l'un parmi le profilé de renfort (20) et le support (40), ce pion (451) étant propre à coopérer avec un orifice (251) de l'autre parmi le profilé de renfort (20) et le support (40) pour l'alignement des moyens d'encliquetage (48) du support (40) par rapport au profilé de renfort (20).

8. Arrangement selon l'une quelconque des revendications précédentes, **caractérisé en ce que** le support (40) est un flan métallique plié et découpé pour former les moyens d'encliquetage.

9. Arrangement selon l'une quelconque des revendications précédentes, **caractérisé en ce que** le profilé de renfort (20) du module est de forme allongée et adapté pour coopérer par encliquetage avec un support (40) au niveau de chacune de ses extrémités (20A, 20B).

10. Arrangement selon l'une quelconque des revendications précédentes, **caractérisé en ce que** le module (10) comprend au moins deux profilés de renfort (20) solidaires de sa face arrière (10A) et régulièrement répartis sur ladite face arrière (10A).

11. Arrangement selon l'une quelconque des revendications précédentes, **caractérisé en ce que** le module (10) est un module photovoltaïque dépourvu de cadre, qui comprend un substrat avant (11), un substrat arrière (12) et au moins une cellule photovoltaïque (13) intercalée entre les substrats avant (11) et arrière (12), le ou chaque profilé de renfort (20) étant solidaire d'une face arrière (10A) du substrat arrière (12) opposée à la cellule photovoltaïque (13).

12. Procédé de montage d'un arrangement selon l'une quelconque des revendications précédentes, **caractérisé en ce qu'**il comprend des étapes dans lesquelles :
- on solidarise au moins un support (40) avec la structure (30) ;
- on aligne les moyens d'encliquetage (48) du support (40) par rapport au profilé de renfort (20) ;
- on active les moyens d'encliquetage (28, 48) par l'application d'un effort unidirectionnel (F₁) de poussée du module (10) en direction de la structure (30).

## Patentansprüche

1. Anordnung, welche umfasst:
- eine Vorrichtung (1) zum Befestigen eines Moduls (10) zur Gewinnung von Energie aus Sonnenstrahlung an einer Struktur (30), wie einem Dach, einer Fassade oder einer tragenden Struktur im Gelände,
- ein Modul (10) zur Gewinnung von Energie aus Sonnenstrahlung, wobei das Modul (10) auf seiner Rückseite (10A) mit mindestens einem Verstärkungsprofil (20) versehen ist,
wobei das mindestens eine Verstärkungsprofil (20) in Bezug auf die Umfangsränder (18) des Moduls (10) nach innen versetzt ist und wobei die Befestigungsvorrichtung mindestens einen mit der Struktur (30) verbundenen Träger (40) umfasst, wobei dieser mindestens eine Träger (40) Mittel (48) zum Einrasten des Verstärkungsprofils (20) des Moduls umfasst, die durch Anwenden einer unidirektionalen Druckkraft (F₁) des Moduls (10) in Richtung der Struktur (30) aktiviert werden können,
**dadurch gekennzeichnet, dass** wenigstens ein Träger (40) für die Verriegelung der Einrastmittel in ihrem aktiven Zustand elastische Mittel (46) zum Drücken (P) des Moduls (10) weg von der Struktur (30) umfasst.

2. Anordnung nach Anspruch 1, **dadurch gekennzeichnet, dass** die Einrastmittel mindestens eine Zunge (48) des Trägers (40) umfassen, die geeignet ist, durch Einrasten mit einer Kerbe (28) des Verstärkungsprofils (20) zusammenzuwirken.

3. Anordnung nach Anspruch 2, **dadurch gekennzeichnet, dass** die Zunge (48) eine Nut (49) zur Aufnahme einer Kante (281) der Kerbe (28) definiert, wobei diese Nut (49) zur Struktur (30) hin offen ist.

4. Anordnung nach Anspruch 3, **dadurch gekennzeichnet, dass** sie als Mittel zum Verriegeln der Einrastmittel in ihrem aktivierten Zustand elastische Mittel (46) zum Wegdrücken (P) des Moduls (10) von der Struktur (30) umfasst, um die Kante (281) innerhalb der Nut (49) zu halten.

5. Anordnung nach Anspruch 4, **dadurch gekennzeichnet, dass** das Verstärkungsprofil (20) eine Entriegelungsöffnung (29) aufweist, die im aktivierten Zustand der Einrastmittel der Zunge (48) gegenüber liegt, wobei die Einrastmittel in der Lage sind, von ihrem aktivierten Zustand in einen deaktivierten Zustand überzugehen unter der kombinierten Wirkung einer Kraft (F₂) zum Drücken des Moduls (10) in Richtung der Struktur (30) gegen die elastischen Mittel (46) und einer Kraft (F₃) zum Wegdrücken der Zunge (48) von der Kerbe (28), die durch die Entriegelungsöffnung (29) ausgeübt wird.

6. Anordnung nach einem der vorhergehenden Ansprüche, **dadurch gekennzeichnet, dass** das Verstärkungsprofil (20) mindestens einen Abschnitt (22-24) mit einem U-förmigen Querschnitt aufweist, der im Wesentlichen komplementär zu dem U-förmigen Querschnitt eines Abschnitts (42-44) des Trägers (40) ist, wobei diese U-förmigen Abschnitte (22-24, 42-44) im aktivierten Zustand der Einrastmittel ineinandergreifen.

7. Anordnung nach einem der vorhergehenden Ansprüche, **dadurch gekennzeichnet, dass** sie mindestens einen Stift (451) umfasst, der mit dem Verstärkungsprofil (20) oder dem Träger (40) verbunden ist, wobei der Stift (451) geeignet ist, mit einer Öffnung (251) des jeweils anderen aus Verstärkungsprofil (20) und Träger (40) für die Ausrichtung der Einrastmittel (48) des Trägers (40) in Bezug auf das Verstärkungsprofil (20) zusammenzuwirken.

8. Anordnung nach einem der vorhergehenden Ansprüche, **dadurch gekennzeichnet, dass** der Träger (40) ein Metallzuschnitt ist, der zur Bildung der Einrastmittel gefaltet und geschnitten ist.

9. Anordnung nach einem der vorhergehenden Ansprüche, **dadurch gekennzeichnet, dass** das Verstärkungsprofil (20) des Moduls eine längliche Form aufweist und dazu geeignet ist, durch Einrasten mit einem Träger (40) an jedem seiner Enden (20A, 20B) zusammenzuwirken.

10. Anordnung nach einem der vorhergehenden Ansprüche, **dadurch gekennzeichnet, dass** das Modul (10) mindestens zwei Verstärkungsprofile (20) aufweist, die mit seiner Rückseite (10A) verbunden und gleichmäßig über die Rückseite (10A) verteilt sind.

11. Anordnung nach einem der vorhergehenden Ansprüche, **dadurch gekennzeichnet, dass** das Modul (10) ein rahmenloses photovoltaisches Modul ist, das ein vorderes Substrat (11), ein hinteres Substrat (12) und mindestens eine photovoltaische Zelle (13) umfasst, die zwischen dem vorderen (11) und dem hinteren (12) Substrat angeordnet ist, wobei das oder jedes Verstärkungsprofil (20) mit einer Rückseite (10A) des hinteren Substrats (12) gegenüber der photovoltaischen Zelle (13) verbunden ist.

12. Verfahren zur Montage einer Anordnung nach einem der vorhergehenden Ansprüche, **dadurch gekennzeichnet, dass** es Schritte umfasst, in denen:
- mindestens ein Träger (40) mit der Struktur (30) verbunden wird;
- die Mittel (48) zum Einrasten des Trägers (40) mit dem Verstärkungsprofil (20) ausgerichtet werden;
- die Einrastmittel (28, 48) durch die Anwendung einer unidirektionalen Druckkraft (F₁) des Moduls (10) in Richtung der Struktur (30) aktiviert werden.

## Claims

1. Arrangement comprising:
- a device (1) for attaching a solar radiation energy recovery module (10) to a structure (30), such as a roof, a facade or a supporting structure in the field,
- a solar radiation energy recovery module (10),
where the module (10) is provided on its rear face (10A) with at least one reinforcing profile (20), where the at least one reinforcing profile (20) is offset internally with respect to the peripheral edges (18) of the module (10) and where the fixing device comprises at least one support (40) integral with the structure (30), this at least one support (40) comprising means (48) for snap-fastening with respect to the reinforcing profile (20) of the module, which are capable of being activated by the application of a unidirectional thrust force (F₁) of the module (10) in the direction of the structure (30), **characterized in that** the support (40) comprises, for locking the snap-fastening means in their activated state, elastic means (46) for thrusting (P) the module (10) away from the structure (30).

2. Arrangement according to claim 1, **characterised in that** the snap-fastening means comprise at least one tongue (48) of the support (40) capable of cooperating by snap-fitting with a notch (28) of the reinforcing profile (20).

3. Arrangement according to claim 2, **characterised in that** the tongue (48) defines a groove (49) for receiving an edge (281) of the notch (28), this groove (49) being open towards the structure (30).

4. Arrangement according to claim 3, **characterised in that** it comprises, as means for locking the snap-fastering means in their activated state, elastic means (46) for pushing (P) the module (10) away from the structure (30) in order to maintain the edge (281) inside the groove (49).

5. Arrangement according to claim 4, **characterised in that** the reinforcing profile (20) comprises an unlocking hole (29) which, in the activated state of the snap-fastening means, is opposite the tongue (48), the snap-fastening means being capable of passing from their activated state to a deactivated state under the combined effect of a force (F₂) for pushing the module (10) in the direction of the structure (30) against the elastic means (46) and of a force (F3) for pushing the tongue (48) away from the notch (28) exerted through the unlocking orifice (29)

6. Arrangement according to any one of the preceding claims, **characterised in that** the reinforcing profile (20) comprises at least one portion (22-24) with a U-shaped cross-section substantially complementary to the U-shaped cross-section of a portion (42-44) of the support (40), these U-shaped portions (22-24, 42-44) engaging each other in the activated state of the snap-fastening means.

7. Arrangement according to any one of the preceding claims, **characterised in that** it comprises at least one pin (451) integral with one of the reinforcing profile (20) and the support (40), said pin (451) being adapted to cooperate with an orifice (251) of the other of the reinforcing profile (20) and the support (40) for the alignment of the snap-fastening means (48) of the support (40) relative to the reinforcing profile (20).

8. Arrangement according to any one of the preceding claims, **characterised in that** the support (40) is a metal blank folded and cut to form the snap-fastening means.

9. Arrangement according to any one of the preceding claims, **characterised in that** the reinforcing profile (20) of the module is elongate in shape and adapted to snap-fasten with a support (40) at each of its ends (20A, 20B).

10. Arrangement according to any one of the preceding claims, **characterised in that** the module (10) comprises at least two reinforcing profiles (20) integral with its rear face (10A) and evenly distributed over said rear face (10A).

11. Arrangement according to any one of the preceding claims, **characterised in that** the module (10) is a frameless photovoltaic module, which comprises a front substrate (11), a rear substrate (12) and at least one photovoltaic cell (13) interposed between the front (11) and rear (12) substrates, the or each reinforcing profile (20) being integral with a rear face (10A) of the rear substrate (12) opposite the photovoltaic cell (13).

12. Method of mounting of an annrangement according to any one of the preceding claims, **characterised in that** it comprises steps in which:
- at least one support (40) is made integral with the structure (30);
- the means (48) for snap-fastening the support (40) are aligned with the reinforcing profile (20);
- the snap-fastening means (28, 48) are activated by applying a unidirectional thrust force (F₁) from the module (10) in the direction of the structure (30).
